# EUROPÄISCHE PATENTSCHRIFT

(11) **EP 2 519 984 B1**
(45) Veröffentlichungstag und Bekanntmachung des Hinweises auf die Patenterteilung: **05.06.2019**
(21) Anmeldenummer: 11715468.2
(22) Anmeldetag: 13.04.2011
(51) Int. Cl.: H01L 33/44, H01L 33/58

(54) **ELEKTRONISCHE ANORDNUNG**
ELECTRICAL DEVICE
DIPOSITIF ÉLECTRIQUE

(30) Priorität: 27.05.2010 DE 102010029368
(43) Veröffentlichungstag der Anmeldung: 07.11.2012
(73) Patentinhaber: OSRAM Opto Semiconductors GmbH, 93055 Regensburg (DE)
(72) Erfinder: BEMMERL, Thomas, 92421 Schwandorf (DE); JEREBIC, Simon, 93105 Tegernheim (DE); PINDL, Markus, 93194 Walderbach (DE)
(74) Vertreter: Epping - Hermann - Fischer
(86) Internationale Anmeldenummer: PCT/EP2011/055769
(87) Internationale Veröffentlichungsnummer: WO 2011/147636

(56) Entgegenhaltungen:
- EP-A1- 2 144 305
- WO-A1-2009/066206
- WO-A1-2010/035206
- WO-A1-2010/051758
- WO-A2-2009/075530
- DE-A1-102006 046 678
- DE-A1-102007 060 206
- JP-A- 2009 194 026
- JP-A- 2009 295 892
- JP-A- 2010 114 144
- US-A1- 2002 154 366
- US-A1- 2004 036 078
- US-A1- 2004 217 369
- US-A1- 2007 045 800

## Beschreibung

Die vorliegende Erfindung betrifft eine elektronische Anordnung.

Elektronische Anordnungen weisen in ausgeschaltetem Zustand ein inhomogenes optisches Erscheinungsbild auf. Sie können optoelektronische Bauelemente und nicht-optoelektronische Bauelemente aufweisen, deren Kontaktmaterialien und Oberflächen unterschiedliche Farb- und Helligkeitseindrücke vermitteln.

Druckschrift JP 2010-114144 A beschreibt ein lichtemittierendes Bauelement auf einer Trägerplatte mit einer Lötstopplackschicht, wobei eine weiße Harzmasse seitlich des lichtemittierenden Bauelements auf der Trägerplatte derart angeordnet ist, dass die weiße Harzmasse die weiße Lötstopplackschicht und zumindest eine Seitenfläche des lichtemittierenden Bauelements bedeckt.

In der WO 2010/051758 A1 ist ein Beleuchtungsmodul mit einer Mehrzahl von lichtemittierenden Halbleiterchips offenbart. Das Beleuchtungsmodul umfasst ein thermisch leitfähiges Substrat mit einer dunklen Isolierungsschicht, die auf einer Oberfläche des Substrats angeordnet ist. Eine elektrisch leitfähige Schicht ist ebenfalls auf der Oberfläche des Substrats angeordnet, wobei die elektrisch leitfähige Schicht eine Vielzahl von Chipträgern umfasst, die jeweils einem der Halbleiterchips zugeordnet sind. Das Beleuchtungsmodul weist eine reflektierende Schicht auf, die die elektrisch leitfähige Schicht zumindest teilweise bedeckt.

Druckschrift WO 2009/075530 A2 beschreibt eine Vorrichtung mit einem Substrat aufweisend eine Öffnung, in der ein Montagebereich für einen lichtemittierenden Halbleiterchip ausgebildet ist. Die Vorrichtung weist eine Reflexionsschicht auf, die eine Bodenfläche und eine innere Seitenwand der Öffnung um den lichtemittierenden Halbleiterchip herum bedeckt. Bis zu 60 Gewichtsprozent kann die Reflexionsschicht ein Hauptmaterial aus der Gruppe aus TiO2, ZnO, Lithopone, ZnS, BaSO4, SiO2 oder PTFE (Polytetrafluorethylen) enthalten.

Aufgabe der Erfindung ist es, eine elektronische Anordnung vorzusehen, die in ausgeschaltetem Zustand ein homogenes optisches Erscheinungsbild aufweist.

Diese Aufgabe wird durch eine elektronische Anordnung gemäß dem unabhängigen Patentanspruch 1 gelöst.

Weiterbildungen und vorteilhafte Ausgestaltungen der elektronischen Anordnung sind in den abhängigen Ansprüchen angegeben.

### Beispielhafte Ausführungsformen

Verschiedene Ausführungsformen weisen eine elektronische Anordnung mit optoelektronischen und nicht-optoelektronischen Bauelementen auf. Im ausgeschalteten Zustand ist das optische Erscheinungsbild homogenisiert. Im eingeschalteten Zustand des optoelektronischen Bauelements sind die Absorptionsverluste minimiert.

Die elektronische Anordnung weist einen Träger mit mindestens einer Verbindungsfläche auf. Mindestens ein elektronisches Bauelement ist auf der Verbindungsfläche mittels eines Kontaktmaterials befestigt. Eine Deckfläche ist auf dem Träger angeordnet und umgibt die Verbindungsfläche. Die elektronische Anordnung weist mindestens einen abgedeckten Bereich auf, der von einem Abdeckmaterial bedeckt ist. Das Abdeckmaterial ist derart eingerichtet, dass ein optischer Kontrast zwischen der Deckfläche und dem abgedeckten Bereich minimiert ist.

In einer bevorzugten Ausführungsform ist die Verbindungsfläche eine elektrische, vorzugsweise metallische, Kontaktierungsfläche.

Alternativ oder ergänzend ist die Verbindungsfläche eine, insbesondere nichtmetallische, Klebefläche. Dies kann bei optoelektronischen Bauelementen, die auf Saphir aufgewachsen sind, zur Anwendung kommen.

Der optische Kontrast bezieht sich auf einen Farbkontrast. Alternativ oder ergänzend bezieht sich der optische Kontrast auch auf einen Helligkeitskontrast. Minimiert wird der optische Kontrast zum einen dadurch, dass die Deckfläche und das Abdeckmaterial eine ähnliche, vorzugsweise eine identische, Reflektivität aufweisen. Zum anderen wird der optische Kontrast dadurch minimiert, dass die Deckfläche und das Abdeckmaterial eine ähnliche, vorzugsweise eine identische, Farbe aufweisen.

Farbortunterschiede und damit der Farbkontrast können durch den Farbabstand ΔE dargestellt werden. Synonym zu "gleicher Farbe" ist der Begriff "gleiche Farbvalenz" zu verwenden. Farbabstände ΔE<2 sind für das menschliche Auge kaum wahrnehmbar. Im Gegensatz dazu werden Farbabstände von ΔE>5-10 als andere Farben wahrgenommen. Die Farbe der Deckfläche und die Farbe des Abdeckmaterials weisen bevorzugt einen Farbabstand von ΔE<5, besonders bevorzugt von ΔE<3 auf.

Die Ähnlichkeit des Helligkeitseindruckes von Abdeckmaterial zu Deckfläche kann in Reflexionsgradunterschiede ausgedrückt werden. Vor der Abdeckung weist z.B. das Goldbedeckte Bondpad einen Reflexionsgrad von ca. 55 % auf. Das Material der Deckfläche kann einen Reflexionsgrad von etwa 95 % aufweisen. Die damit definierten 40 % Unterschied sind als der störende Ausgangszustand definierbar. Der Unterschied in der Reflektivität von Deckfläche zur Reflektivität des Abdeckmaterials beträgt erfindungsgemäß weniger als 20 % und besonders bevorzugt weniger als 10 %. Jede Verringerung des Unterschieds der Reflektivitäten von Deckfläche und Abdeckmaterial erzeugt einen homogeneren Helligkeitseindruck.

Neben der Kontrastminimierung führt das teilweise oder vollständige Abdecken von elektronischen Bauelementen mit Abdeckmaterial zu einem Korrosionsschutz für die elektronischen Bauelemente.

Der Einsatz von Abdeckmaterial ist vorteilhaft gegenüber dem Einsatz von Linsen aus diffusen Kunststoff oder Aufrauen von Linsenoberflächen oder Beschichten der Linsenoberfläche mit diffusem Harz.

In einer bevorzugten Ausführungsform weist das Kontaktmaterial Lot oder Klebstoff auf. Dies ist vorteilhaft, da dadurch das elektronische Bauelement mechanisch und/oder elektrisch leitend mit der Verbindungsfläche verbindbar ist.

In einer erfindungsgemäßen Ausführungsform ist das elektronische Bauelement ein optoelektronisches Bauelement, insbesondere eine LED. Das optoelektronische Bauelement kann auf einem III-V-Verbindungshalbleitermaterial, insbesondere ein Nitridverbindungshalbleitermaterial wie Galliumnitrid (GaN) aufgewachsen sein. Das optoelektronisches Bauelement weist mindestens eine aktive Zone auf, die elektromagnetische Strahlung emittiert. Die aktiven Zonen können pn-Übergänge, Doppelheterostruktur, Mehrfach-Quantentopfstruktur (MQW), Einfach-Quantentopfstruktur (SQW) sein. Quantentopfstruktur bedeutet: Quantentöpfe (3-dim), Quantendrähte (2-dim) und Quantenpunkte (1-dim).

In einer bevorzugten Ausführungsform weist die elektronische Anordnung zusätzlich ein nicht-optoelektronisches Bauelement auf. Als nicht-optoelektronisches Bauelement kann ein ESD-Halbleiterchip und/oder ein Mikrochip, zum Beispiel ein Speicher oder ein Controller, zum Einsatz kommen. Alternativ oder ergänzend kann als nicht-optoelektronisches Bauelement ein passives Bauelement, insbesondere ein Widerstand, eine Spule oder ein Kondensator, zum Einsatz kommen.

In einer bevorzugten Ausführungsform ist das optoelektronische Bauelement ein drahtkontaktierter Halbleiterchip. Alternativ oder ergänzend kann das optoelektronische Bauelement als Flipchip ausgestaltet sein. Die Ausführungsform mit einem optoelektronischen Bauelement in Form eines Flipchips ist deshalb vorteilhaft, da die Abschattung durch den Bonddraht entfällt und keine aktive Fläche durch das Bondpad auf dem optoelektronischen Bauelement verloren geht.

In einer bevorzugten Ausführungsform umfasst der vom Abdeckmaterial abgedeckte Bereich die vom Träger abgewandte Fläche des nicht-optoelektronischen Bauelements.

In einer erfindungsgemäßen Ausführungsform umfasst der abgedeckte Bereich die Seitenflächen des elektronischen Bauelements.

In einer erfindungsgemäßen Ausführungsform umfasst der abgedeckte Bereich die vom elektrischen Bauelement nicht bedeckten Bereiche der Verbindungsfläche.

In einer erfindungsgemäßen Ausführungsform umfasst der abgedeckte Bereich die vom elektrischen Bauelement nicht bedeckten Bereiche des Kontaktmaterials.

In einer bevorzugten Ausführungsform können die Bonddrähte vom Abdeckmaterial bedeckt sein.

In einer bevorzugten Ausführungsform können Befestigungseinheiten, insbesondere Schrauben, vom Abdeckmaterial bedeckt sein.

In einer bevorzugten Ausführungsform können die nicht-optoelektronischen Bauelemente vollständig von Abdeckmaterial bedeckt sein. Die vollständige Abdeckung der nicht-optoelektronischen Bauelemente ist besonders vorteilhaft, da damit der Kontrast zwischen bedecktem Bauelement und Deckfläche minimiert ist, vorzugsweise verschwindet.

Die abgedeckten Bereiche sind vorteilhaft, da durch das Abdecken das optische Erscheinungsbild der elektronischen Anordnung in ausgeschaltetem Zustand homogenisiert wird. Zudem ist es vorteilhaft, dass die Lichtabsorption an schlecht reflektierenden Oberflächen der elektronischen Anordnung reduziert wird.

In einer bevorzugten Ausführungsform weist die Deckfläche ein keramisches, vorzugsweise weißes, Material auf. Alternativ oder ergänzend hierzu weist die Deckfläche ein auflaminiertes Epoxydharz auf. Alternativ oder ergänzend hierzu weist die Deckfläche Lötstopplack auf.

In einer bevorzugten Ausführungsform weist das Abdeckmaterial ein eingefärbtes Silikon auf. Alternativ oder ergänzend hierzu weist das Abdeckmaterial ein eingefärbtes Epoxydharz, insbesondere Lötstopplack, auf. Alternativ oder ergänzend hierzu weist das Abdeckmaterial ein Thermoplast auf.

In einer bevorzugten Ausführungsform ist das Abdeckmaterial durch Pigmente, insbesondere durch Titandioxid(TiO₂)-Partikel, eingefärbt.

In einer bevorzugten Ausführungsform sind Titandioxid-Partikel im Abdeckmaterial mit einem Anteil von bis zu 70 Gewichtsprozent, vorzugsweise mit etwa 25 Gewichtsprozent, vorgesehen.

Erfindungsgemäß ist die Deckfläche hochreflektierend mit einer Reflektivität von größer 70 %. Ergänzend hierzu ist das Abdeckmaterial hochreflektierend mit einer Reflektivität von größer 70 %.

Verschiedene Ausführungsformen weisen ein Verfahren zum Herstellen einer elektronischen Anordnung auf. In einer bevorzugten Ausführungsform wird eine Deckfläche flächig und strukturiert auf einen Träger aufgebracht. Dabei wird die mindestens eine Verbindungsfläche ausgespart. Anschließend wird mindestens ein elektronisches Bauelement auf der Verbindungsfläche angebracht. Anschließend werden zumindest teilweise freiliegende Bereiche auf der Verbindungsfläche abgedeckt.

Alternativ oder ergänzend wird bei einem nicht-optoelektronischen Bauelement die vom Träger abgewandte Fläche des elektronischen Bauelements mit Abdeckmaterial abgedeckt.

In einer bevorzugten Ausführungsform erfolgt das Abdecken mit einem Abdeckmaterial durch Dispensieren oder Dosieren.

In einer bevorzugten Ausführungsform erfolgt das Abdecken mit einem Abdeckmaterial durch Jetten.

### Kurze Beschreibung der Zeichnungen

Verschiedene Ausführungsbeispiele der erfindungsgemäßen Lösung werden im Folgenden anhand der Zeichnungen näher erläutert.
Figur 1 zeigt in Schnittansicht einen Ausschnitt einer elektronischen Anordnung mit einem optoelektronischen Bauelement;
Figur 2a und 2b zeigen Draufsichten auf einen Ausschnitt einer elektronischen Anordnung mit einem optoelektronischen Bauelement mit Drahtkontaktierung;
Figur 3a und 3b zeigen Draufsichten auf einen Ausschnitt einer elektronischen Anordnung mit einem optoelektronischen Bauelement mit Flipchip-Kontaktierung;
Figur 4 zeigt in Schnittansicht einen Ausschnitt einer elektronischen Anordnung mit einem nicht- optoelektronischen Bauelement;
Figur 5 zeigt in Schnittansicht einen Ausschnitt einer elektronischen Anordnung mit einem optoelektronischen und einem nicht-optoelektronischen Bauelement;
Figur 6a zeigt in Schnittansicht einen Ausschnitt einer elektronischen Anordnung mit einem nicht-optoelektronischen Bauelement, insbesondere einem passiven Bauelement;
Figuren 6b und 6c zeigen in Draufsicht einen Ausschnitt einer elektronischen Anordnung mit einem nicht-optoelektronischen Bauelement, insbesondere einem passiven Bauelement;
Figur 7a zeigt in Schnittansicht einen Ausschnitt einer elektronischen Anordnung mit einem nicht-optoelektronischen Bauelement, insbesondere einem passiven Bauelement; und
Figuren 7b und 7c zeigen in Draufsicht einen Ausschnitt einer elektronischen Anordnung mit einem nicht-optoelektronischen Bauelement, insbesondere einem passiven Bauelement.

### Ausführungsbeispiele

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und zum besseren Verständnis übertrieben groß dargestellt sein.

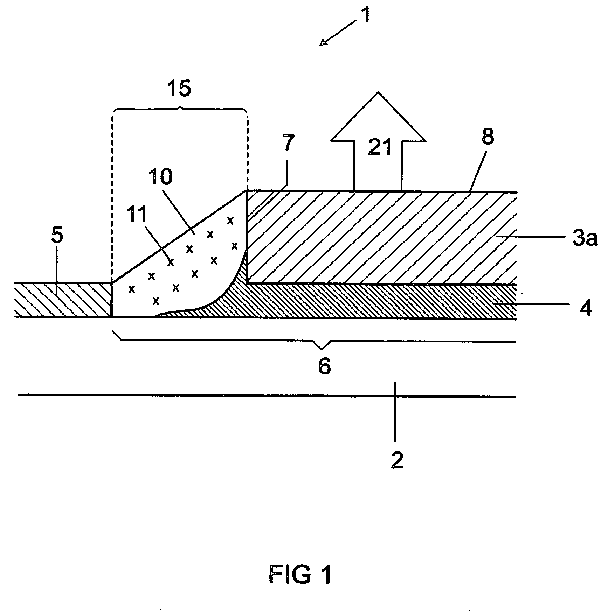

Figur 1 zeigt einen Schnitt eines Ausschnitts einer elektronischen Anordnung 1. Auf einem Träger 2 ist eine Verbindungsfläche 6 angeordnet. Ein optoelektronisches Bauelement 3a ist auf der Verbindungsfläche 6 mittels eines Kontaktmaterials 4 befestigt. Eine Deckfläche 5 umgibt die Verbindungsfläche 6 auf dem Träger 2. Ein abgedeckter Bereich 15 ist von einem Abdeckmaterial 10 bedeckt. Das Abdeckmaterial 10 ist derart eingerichtet, dass ein optischer Kontrast zwischen der Deckfläche 5 und dem abgedeckten Bereich 15 minimiert ist.

Die Verbindungsfläche 6 kann eine elektrische Kontaktierungsfläche sein. Alternativ kann die Verbindungsfläche 6 auch eine, insbesondere nichtmetallische, Klebefläche sein.

Der optische Kontrast ist ein Farbkontrast und/oder ein Helligkeitskontrast.

Das Kontaktmaterial 4 kann ein Lot oder ein Klebstoff sein. Das optoelektronische Bauelement 3a kann eine LED sein.

Der abgedeckte Bereich 15 umfasst die Seitenflächen 7 des optoelektronischen Bauelements 3a, die vom optoelektronischen Bauelements 3a nicht bedeckten Bereiche der Verbindungsfläche 6 und die vom optoelektronischen Bauelement 3a nicht bedeckten Bereiche des Kontaktmaterials 4. Die vom Träger 2 abgewandte Fläche 8 des optoelektronischen Bauelements 3a weist kein Abdeckmaterial 10 auf. Die in der aktiven Zone erzeugte elektromagnetische Strahlung 21 wird vorzugsweise durch die vom Träger 2 abgewandte Fläche 8 emittiert.

Die Deckfläche 5 kann ein keramisches, vorzugsweise weißes, Material sein. Alternativ oder ergänzend hierzu kann die Deckfläche 5 ein auflaminiertes Epoxydharz sein. Alternativ oder ergänzend hierzu kann die Deckfläche 5 Lötstopplack oder ein Thermoplast (premold Package) aufweisen.

Das Abdeckmaterial 10 kann ein eingefärbtes Silikon sein. Alternativ oder ergänzend hierzu kann das Abdeckmaterial 10 ein eingefärbtes Epoxydharz, insbesondere Lötstopplack, sein. Alternativ oder ergänzend hierzu kann das Abdeckmaterial 10 ein Thermoplast aufweisen.

Das Abdeckmaterial 10 kann durch Pigmente 11, insbesondere durch Titandioxid(TiO₂)-Partikel, eingefärbt sein. Die Titandioxid-Partikel sind im Abdeckmaterial bis zu einem Anteil von etwa 70 Gewichtsprozent, vorzugsweise mit etwa 25 Gewichtsprozent, vorgesehen.

Die Deckfläche 5 und das Abdeckmaterial (10) sind hochreflektierend. Die jeweiligen Reflektivitäten sind dabei größer 70 %.

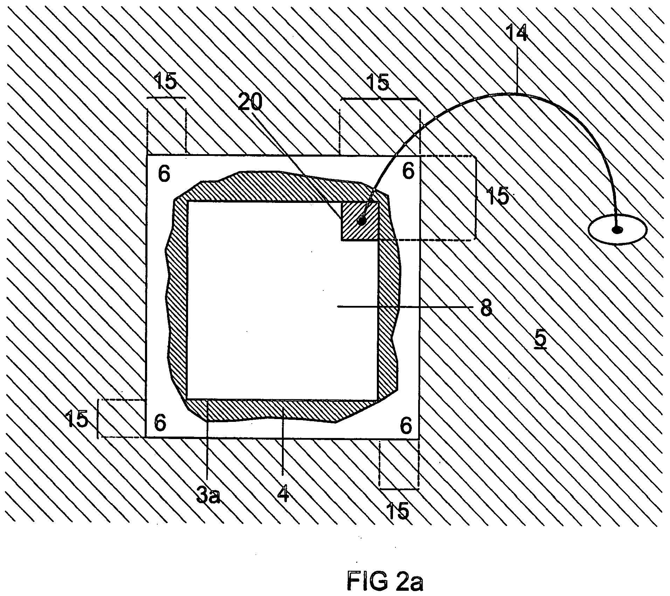

Figur 2a zeigt eine Draufsicht auf eine elektronische Anordnung vor dem Aufbringen von Abdeckmaterial 10. Ein optoelektronisches Bauelement 3a ist mittels eines Kontaktmaterials 4 auf der Verbindungsfläche 6 befestigt. Das optoelektronische Bauelement 3a ist als drahtkontaktierter Halbleiterchip realisiert. Die Kontaktierung erfolgt über ein Bondpad 20 auf dem optoelektronischen Bauelement 3a mittels eines Bonddrahts 14.

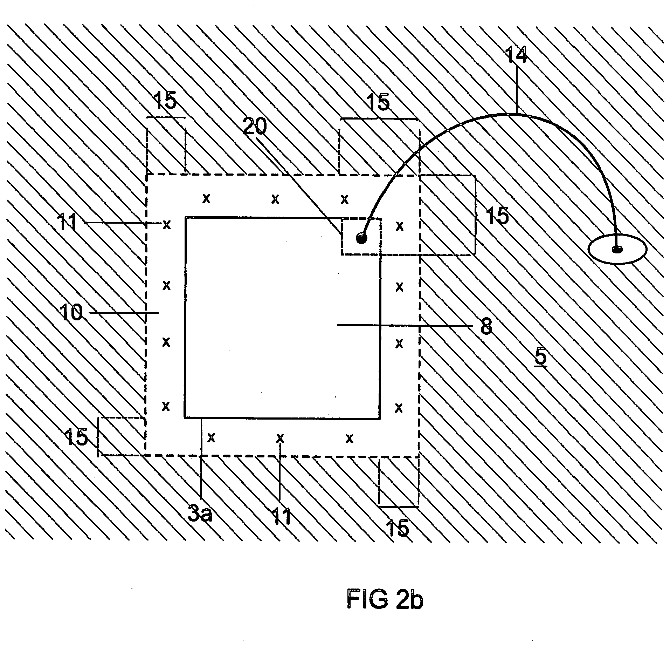

Für den Betrachter ist um das optoelektronische Bauelement 3a an allen Seiten Kontaktmaterial 4 erkennbar. Auch auf dem Bondpad 20 des optoelektronischen Bauelements 3a ist Kontaktmaterial 4 erkennbar. Zwischen den Bereichen mit freiliegendem Kontaktmaterial 4 und Deckfläche 5 ist unmittelbar die Verbindungsfläche 6 erkennbar. Das Kontaktmaterial 4 und die Verbindungsfläche 6 sind im Vergleich zur Deckfläche 5 dunkel gefärbt und heben sich von der Deckfläche 5 im Hinblick auf Farbe und Helligkeit deutlich ab. Diese dunkle Färbung ist für den Betrachter einer elektronischen Anordnung 1 mit einem optoelektronischen Bauelement 3a im ausgeschalteten Zustand ästhetisch störend. Zudem führen die dunklen Bereiche der elektronischen Anordnung 1 mit einem optoelektronischen Bauelement 3a im eingeschalteten Zustand zu unerwünschten Absorptionsverlusten. Um beide Probleme zu lösen bzw. zu reduzieren wird auf den Bereich 15 mit freiliegender Verbindungsfläche 6 und freiliegendem Kontaktmaterial 4 ein Abdeckmaterial 10 aufgebracht. Das Resultat ist in Figur 2b zu sehen.

Figur 2b zeigt eine Draufsicht auf eine elektronische Anordnung nach dem Aufbringen von Abdeckmaterial 10. Der Bereich 15 ist vollständig mit Abdeckmaterial 10 abgedeckt. Die Pigmente 11 im Abdeckmaterial 10 und das Abdeckmaterial 10 selbst, führen dazu, dass der Kontrast zwischen abgedecktem Bereich 15 und Deckfläche 5 verschwindet. Deshalb ist die Grenze zwischen abgedeckten Bereich 15 und Deckfläche 5 gestrichelt eingezeichnet. Die vom Träger 2 abgewandte Fläche 8 des optoelektronischen Bauelements 3a weist kein Abdeckmaterial 10 auf.

In einem nicht gezeigten Ausführungsbeispiel ist auch der Bonddraht 14 mit Abdeckmaterial 10 bedeckt.

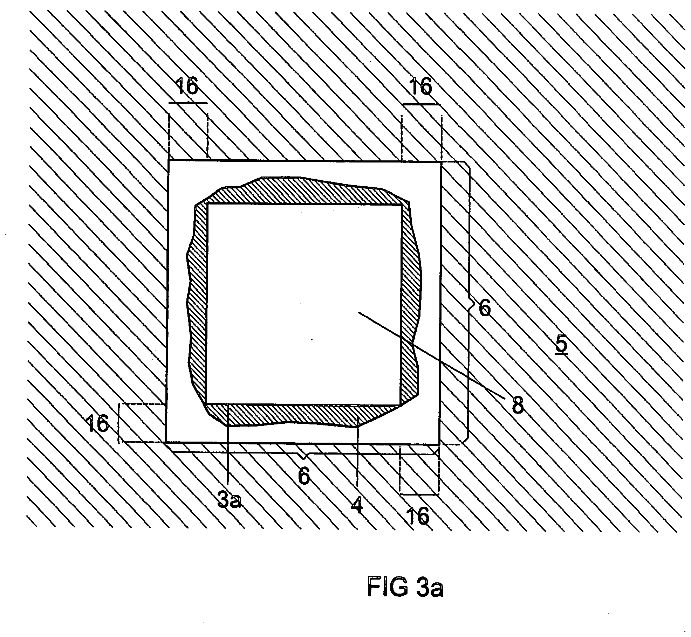

Figur 3a zeigt eine elektronische Anordnung bei der das optoelektronische Bauelement als Flipchip ausgestaltet ist. Die Anordnung ist identisch zur Anordnung in Figur 2a, außer dass in Figur 3a der Bondpad 20 und der Bonddraht 14 aus Figur 2a entfällt. Dies wird dadurch ermöglicht, dass die Kontaktierung des optoelektronischen Bauelements 3a vollständig über die Rückseite des optoelektronischen Bauelements 3a erfolgt.

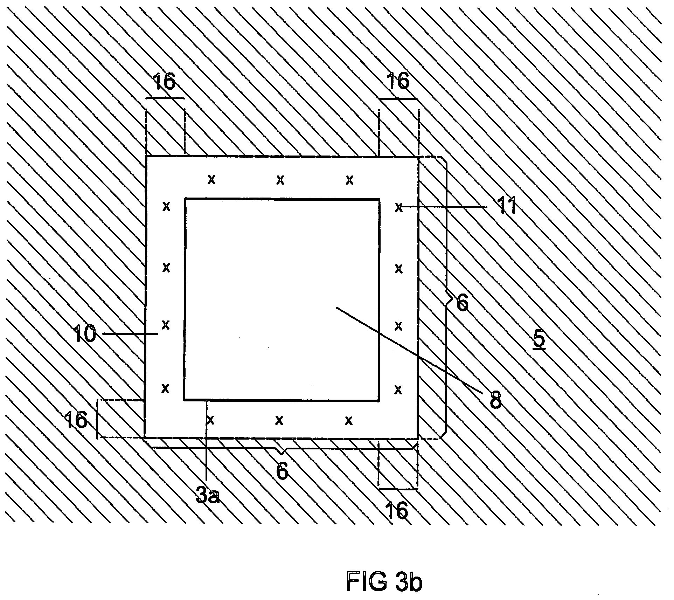

Figur 3b zeigt eine elektronische Anordnung bei der das optoelektronische Bauelement 3a als Flipchip ausgestaltet ist und der freiliegende Bereich zwischen dem optoelektronischen Bauelement 3a und der Deckfläche 5 abgedeckt ist. Der abgedeckte Bereich 16 ist vom Abdeckmaterial 10 derart abgedeckt, dass sich ein Bereich zwischen dem leuchtfähigen Halbleiterchip 3a und der Deckfläche 5 ergibt, der einen minimalen Kontrast zur Deckfläche 5 aufweist.

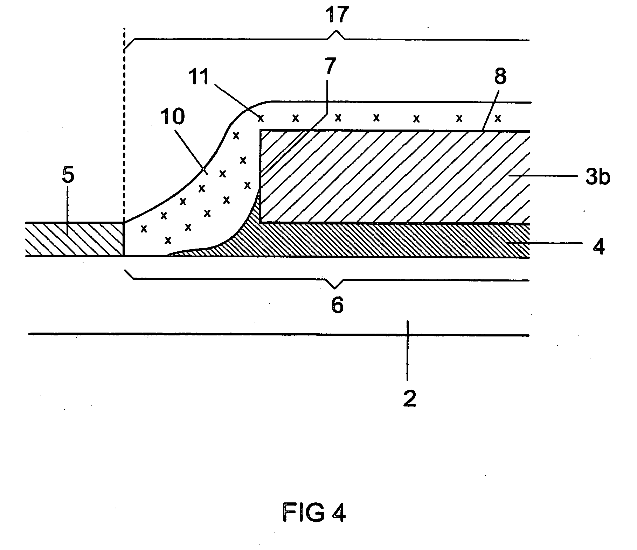

Figur 4 zeigt eine elektronische Anordnung wobei das elektronische Bauelement ein nicht-optoelektronisches Bauelement 3b, insbesondere ein ESD-Halbleiterchip und/oder ein Mikrochip, zum Beispiel ein Speicher oder ein Controller, ist. Da das nicht-optoelektronische Bauelement 3b keine elektromagnetische Strahlung emittiert oder sensiert, kann die komplette, vom Träger 2 abgewandte, Fläche 8 des nicht-optoelektronischen Bauelements 3b mit Abdeckmaterial 10 bedeckt sein. Wie schon in Figur 1 gezeigt, können auch im Falle eines nicht optoelektronischen Bauelements 3b, die Seitenflächen 7 und die Bereiche mit freiliegendem Kontaktmaterial 4 und mit freiliegender Verbindungsfläche 6 mit Abdeckmaterial 10 bedeckt sein. Der abgedeckte Bereich 17 bei kompletter Bedeckung des nicht-optoelektronischen Bauelements 3b führt zu einem homogenen Farbeindruck und minimiert die Absorptionsverluste an den Seitenflächen 7 und an der vom Träger 2 abgewandten Fläche 8 des nicht-optoelektronischen Bauelements 3b.

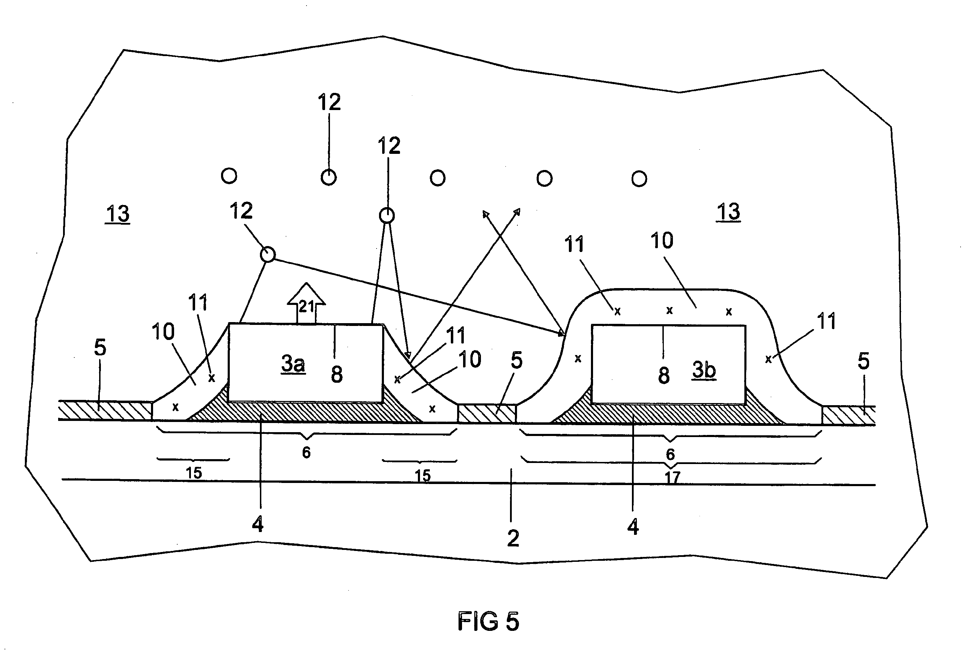

Figur 5 zeigt eine elektronische Anordnung bei der ein optoelektronisches Bauelement 3a und ein nicht-optoelektronisches Bauelement 3b in unmittelbarer Nähe zueinander auf einem Träger 2 angeordnet sind. Der abgedeckte Bereich 15 beim optoelektronischen Bauelement 3a und der abgedeckte Bereich 17 bei kompletter Bedeckung des nicht-optoelektronischen Bauelements 3b sind identisch zu denen in Figur 1 und Figur 4. Die elektronischen Bauelemente 3a und 3b sind mit einem Vergussmaterial 13 vergossen. Im Vergussmaterial 13 sind Streuzentren 12 eingebracht. Die komplette Abdeckung 17 des nicht-optoelektronischen Bauelements 3b und der abgedeckte Bereich 15 beim optoelektronischen Bauelement 3a reduziert die ungewollten Absorptionsverluste. Die elektromagnetische Strahlung 21 die vom optoelektronischen Bauelement 3a ausgeht, wird an den Streuzentren gestreut, insbesondere reflektiert. Die reflektierte Strahlung trifft Großteils auf die abgedeckten Bereiche 15 und 17 und die Deckfläche 5. Das Abdeckmaterial 10 und die Deckfläche 5 sind hochreflektierend ausgelegt. In größerem Maße wird die reflektierte elektromagnetische Strahlung nur noch von der vom Träger 2 abgewandten Fläche 8 des optoelektronischen Bauelements 3a absorbiert.

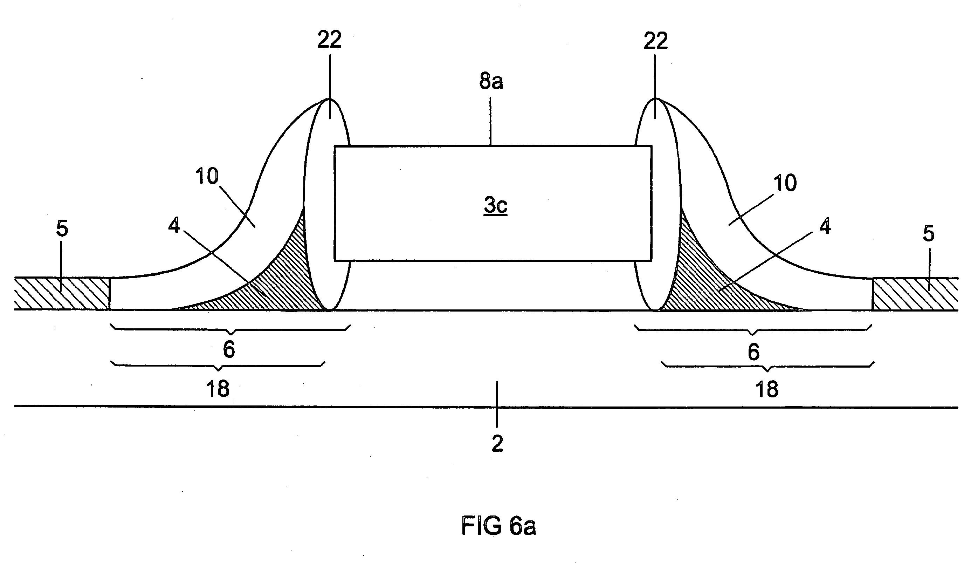

Figur 6a zeigt in Schnittansicht einen Ausschnitt einer elektronischen Anordnung, wobei das elektronische Bauelement ein nicht-optoelektronisches Bauelement 3c ist. Insbesondere kann das nicht-optoelektronische Bauelement 3c ein passives Bauelement sein. Als passives Bauelement können insbesondere ein Widerstand, ein Kondensator oder eine Spule, vorgesehen sein. Vorliegend handelt es sich um ein Bauelement, das eine SMD-Bauform aufweist. Hierbei umfasst der vom Abdeckmaterial 10 abgedeckte Bereich 18 die vom passiven Bauelement 3c nicht bedeckten Bereiche der Verbindungsfläche 6 und die vom passiven Bauelement 3c nicht bedeckten Bereiche des Kontaktmaterials 4. Zwischen den SMD-Lötanschlussflächen 22 des passiven Bauelements 3c und den Verbindungsflächen 6 vermittelt das Kontaktmaterial 4 die elektrische und mechanische Verbindung. Die Deckfläche 5 umgibt wie schon in den vorigen Figuren, die Verbindungsflächen 6. Die vom Träger 2 abgewandte Fläche 8a des passiven Bauelements 3c bleibt unbedeckt.

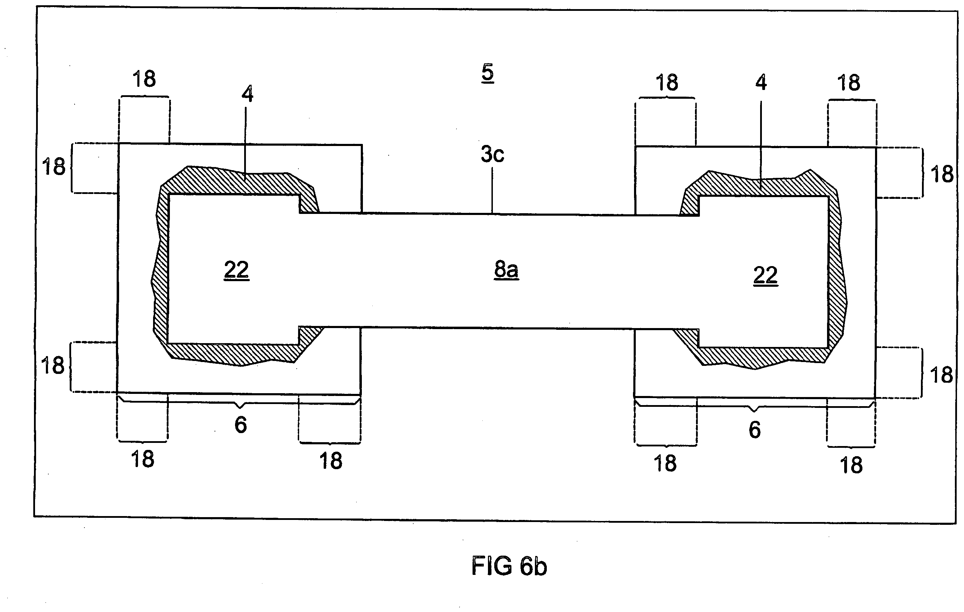

Figur 6b zeigt in Draufsicht den Ausschnitt der elektronischen Anordnung aus Figur 6a vor dem Abdecken freiliegender Bereiche durch ein Abdeckmaterial 10. Durch das Befestigen des passiven Bauelements 3c auf den beiden Verbindungsflächen 6 wird Kontaktmaterial 4 über die Begrenzung der Lötanschlussflächen 22 hinaus verteilt. Der optische Eindruck ist sehr inhomogen.

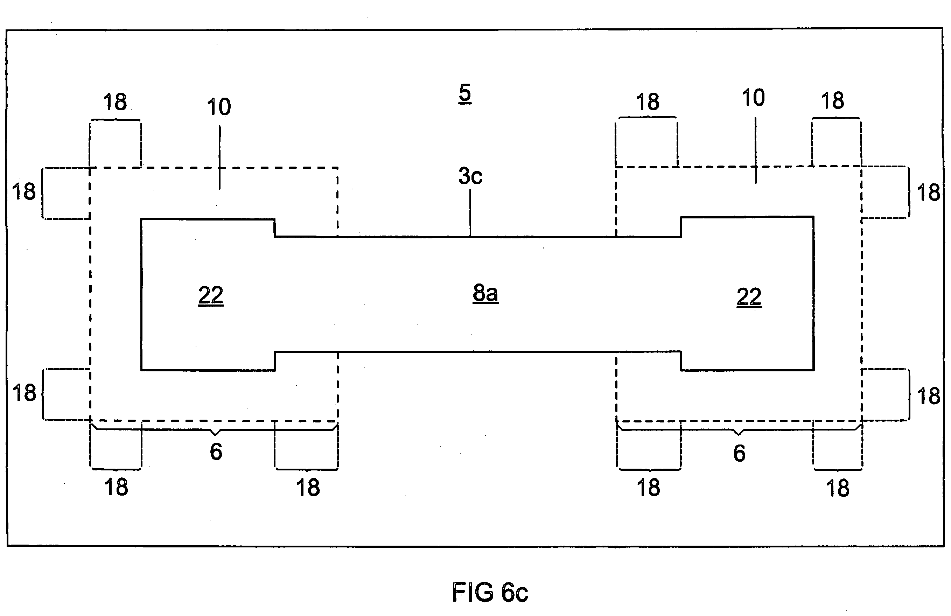

Figur 6c zeigt die Anordnung aus Figur 6b, wobei in Figur 6c die freiliegenden Bereiche auf der Verbindungsfläche 6 und auf dem Kontaktmaterial 4 mit Abdeckmaterial 10 bedeckt sind. Es ergibt sich ein abgedeckter Bereich 18. Wie schon in den vorangehenden Ausführungsbeispielen beschrieben, wird durch das teilweise Abdecken freiliegender Bereiche auch bei passiven Bauelementen 3c der optische Kontrast verringert. Die vom Träger 2 abgewandte Fläche 8a des passiven Bauelements 3c und die Lötanschlussflächen 22 bleiben im Ausführungsbeispiel von Figur 6c von Abdeckmaterial unbedeckt.

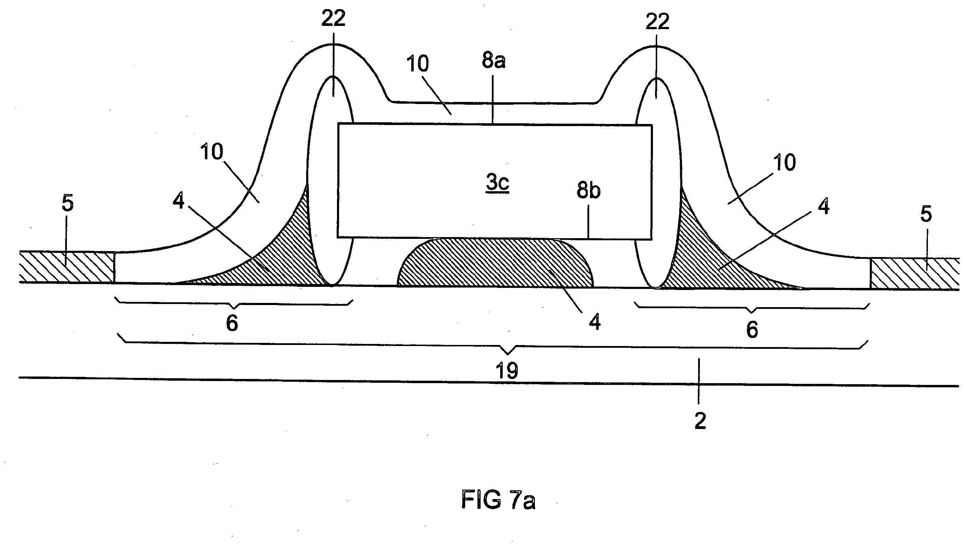

Figur 7a zeigt in Schnittansicht einen Ausschnitt einer elektronischen Anordnung, wobei das elektronische Bauelement wie schon in Figur 6a ein passives Bauelement 3c ist. Das Kontaktmaterial 4, das direkt an die Lötanschlussflächen 22 angrenzt, stellt einen elektrischen und mechanischen Kontakt zwischen passiven Bauelement 3c und den Verbindungsflächen 6 her. Vorzugsweise wird für diese Funktion Lot als Kontaktmaterial 4 verwendet. Zudem vermittelt das Kontaktmaterial 4 einen rein mechanischen Kontakt zwischen der dem Träger 2 zugewandten Fläche 8b des passiven Bauelements 3c und dem Träger. Vorzugsweise wird für diese Funktion ein Klebstoff als Kontaktmaterial 4 verwendet. Das Abdeckmaterial 10 bedeckt das gesamte passive Bauelement 3c, die vom Kontaktmaterial 4 bedeckten Bereiche der Verbindungsflächen 6 und die freiliegenden Bereiche der Verbindungsfläche 6. Das Abdeckmaterial 10 schließt bündig an die Deckfläche 5 an. Es resultiert ein abgedeckter Bereich 19 bei kompletter Bedeckung des passiven Bauelements 3c.

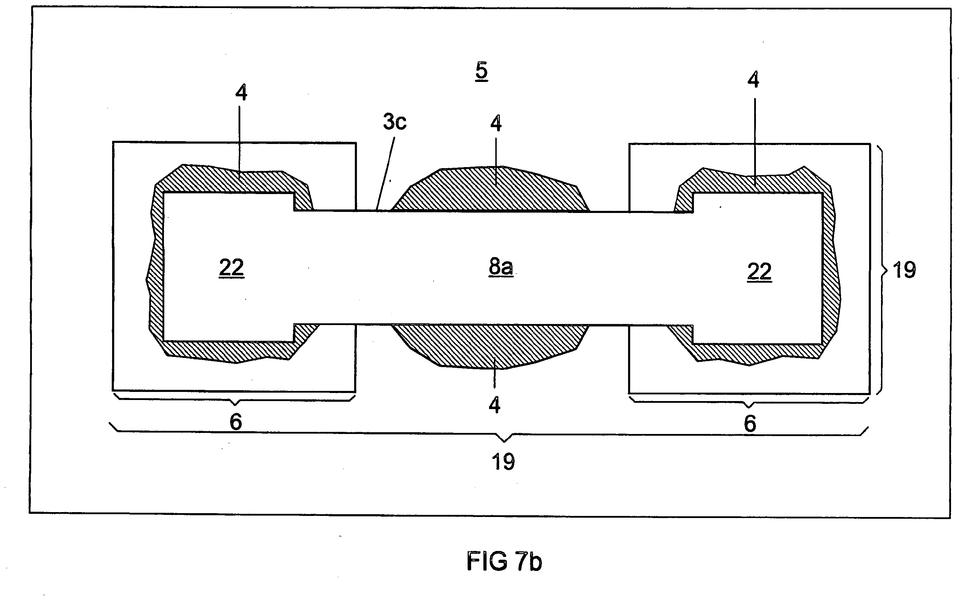

Figur 7b zeigt in Draufsicht den Ausschnitt der elektronischen Anordnung aus Figur 7a vor dem Abdecken freiliegender Bereiche durch ein Abdeckmaterial 10. Durch das Befestigen des passiven Bauelements 3c auf den beiden Verbindungsflächen 6 wird Kontaktmaterial 4 über die Begrenzung der Lötanschlussflächen 22 hinaus verteilt. Zwischen den beiden Lötanschlussflächen 22 ist zwischen dem Träger 2 und der dem Träger 2 zugewandten Fläche 8b (siehe hierzu Figur 7a; nicht in Figur 7b sichtbar) des passiven Bauelements 3c zusätzliches Kontaktmaterial 4 vorgesehen. Dieses zusätzliche Kontaktmaterial 4 ragt seitlich unter dem passiven Bauelement 3c hervor. Durch die freiliegenden Bereiche der Verbindungsflächen 6 und des Kontaktmaterials 4 ist der optische Eindruck sehr inhomogen und es treten bei Kombination mit optoelektronischen Bauelementen Absorptionsverluste auf.

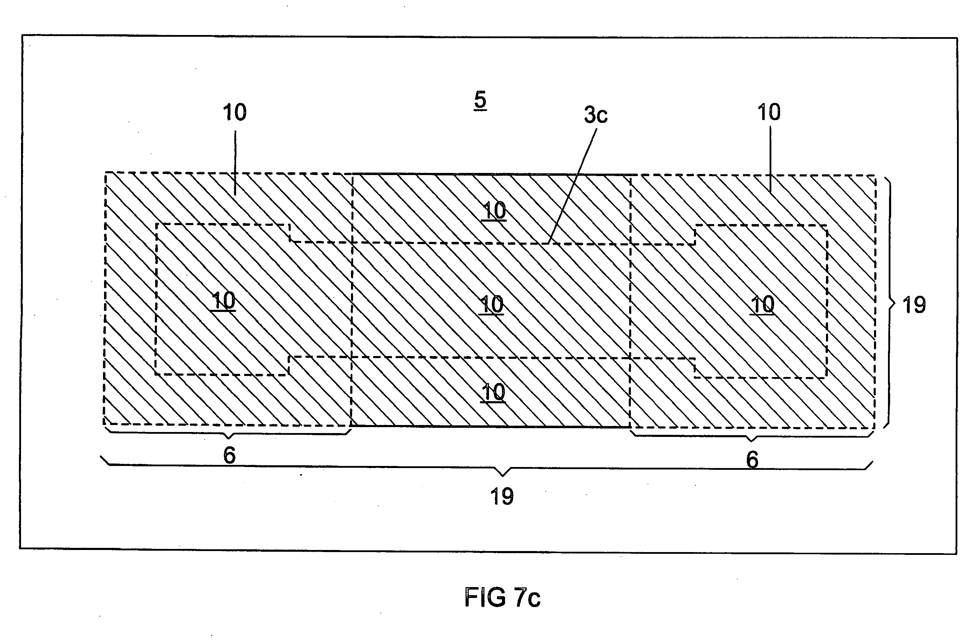

Figur 7c zeigt in Draufsicht den Ausschnitt der elektronischen Anordnung aus Figur 7a, also nach dem Abdecken freiliegender Bereiche durch ein Abdeckmaterial 10. Es ergibt sich ein abgedeckter Bereich 19 bei kompletter Bedeckung des passiven Bauelements 3c. Der Kontrast zwischen Deckfläche 5 und abgedeckten Bereich 19 ist minimiert, vorzugsweise ist kein Kontrast mehr erkennbar. Der optische Eindruck ist sehr homogen. Um dies anzudeuten sind die unter dem abgedeckten Bereich 19 liegenden Strukturen des passiven Bauelements 3c gestrichelt dargestellt.

Die elektronische Anordnung wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso denkbar, in Ausführungsbeispielen einzelne dargestellte Merkmale oder besondere Ausgestaltungen wegzulassen oder hinzuzufügen, soweit die allgemeine technische Lehre realisiert bleibt; die Erfindung ist dabei durch den Anspruchsbereich der beigefügten Ansprüche definiert.

## Patentansprüche

1. Elektronische Anordnung (1) mit:
- einem Träger (2),
- mindestens einer Verbindungsfläche (6) auf dem Träger (2),
- mindestens einem optoelektronischen Bauelement (3a), das zumindest auf der Verbindungsfläche (6) mittels eines Kontaktmaterials (4) befestigt ist,
- einer Deckfläche (5), die die Verbindungsfläche (6) auf dem Träger (2) umgibt, wobei das Kontaktmaterial (4) im Vergleich zur Deckfläche (5) dunkel gefärbt ist und Bereiche aufweist, die von dem optoelektronischen Bauelement (3a) nicht bedeckt sind,
- mindestens einem abgedeckten Bereich (15, 16, 17, 18, 19), der von einem Abdeckmaterial (10) bedeckt ist, wobei der abgedeckte Bereich Seitenflächen (7) des optoelektronischen Bauelements (3a), die vom optoelektronischen Bauelement (3a) nicht bedeckten Bereiche der Verbindungsfläche (6) und die von dem optoelektronischen Bauelement (3a) nicht bedeckten Bereiche des Kontaktmaterials (4) umfasst, wobei der abgedeckte Bereich vollständig mit dem Abdeckmaterial (10) abgedeckt ist und das Abdeckmaterial (10) derart eingerichtet ist, dass ein optischer Kontrast zwischen der Deckfläche (5) und dem abgedeckten Bereich (15, 16, 17, 18, 19) minimiert ist, indem die Deckfläche (5) und das Abdeckmaterial (10) jeweils hochreflektierend mit einer Reflektivität von größer als 70 % sind und ein Unterschied in der Reflektivität der Deckfläche (5) zur Reflektivität des Abdeckmaterials (10) weniger als 20 % beträgt, und
- das optoelektronische Bauelement (3a) derart eingerichtet ist, dass elektromagnetische Strahlung durch eine vom Träger (2) abgewandte Fläche des optoelektronischen Bauelements (3a) emittiert werden kann, und
- die vom Träger (2) abgewandte Fläche des optoelektronischen Bauelements (3a) kein Abdeckmaterial (10) aufweist.

2. Elektronische Anordnung gemäß Anspruch 1,
wobei ein Unterschied in der Reflektivität von Deckfläche (5) zur Reflektivität des Abdeckmaterials (10) weniger als 10 % beträgt.

3. Elektronische Anordnung gemäß einem der Ansprüche 1 oder 2, wobei der optische Kontrast ein Farbkontrast und/oder ein Helligkeitskontrast ist, wobei das Abdeckmaterial (10) und die Deckfläche (5) ähnliche oder identische Reflektivität und/oder Farben aufweisen, sodass der optische Kontrast zwischen der Deckfläche (5) und dem abgedeckten Bereich (15) minimiert ist.

4. Elektronische Anordnung gemäß einem der vorigen Ansprüche, die mindestens ein nicht-optoelektronisches Bauelement (3b, 3c) aufweist, das auf der Verbindungsfläche (6) mittels des Kontaktmaterials (4) befestigt ist.

5. Elektronische Anordnung gemäß Anspruch 4, wobei das nicht-optoelektronische Bauelement (3b, 3c) vollständig von Abdeckmaterial (10) bedeckt ist.

6. Elektronische Anordnung gemäß einem der vorigen Ansprüche, wobei das optoelektronische Bauelement (3a) eine LED umfasst.

7. Elektronische Anordnung gemäß Anspruch 4, wobei das nicht-optoelektronische Bauelement (3b, 3c) einen ESD-Halbleiterchip oder ein passives Bauelement umfasst.

8. Elektronische Anordnung gemäß Anspruch 4, wobei eine vom Träger (2) abgewandte Fläche (8, 8a) des nicht-optoelektronischen Bauelements (3b, 3c) in dem abgedeckten Bereich (17, 19) angeordnet ist.

9. Elektronische Anordnung gemäß einem der Ansprüche 4 oder 5, wobei der abgedeckte Bereich (15, 16, 17, 18, 19) die vom nicht opto-elektrischen Bauelement (3b, 3c) nicht bedeckten Bereiche des Kontaktmaterials (4) umfasst.

10. Elektronische Anordnung gemäß einem der vorigen Ansprüche, wobei die Deckfläche (5) ein keramisches oder weißes Material oder ein auflaminiertes Epoxydharz oder Lötstopplack aufweist.

11. Elektronische Anordnung gemäß einem der vorigen Ansprüche, wobei das Abdeckmaterial (10) ein eingefärbtes Silikon oder mindestens ein eingefärbtes Epoxydharz, oder Lötstopplack oder Thermoplast aufweist.

12. Elektronische Anordnung gemäß Anspruch 11, wobei das Abdeckmaterials (10) durch Pigmente (11) oder durch Titandioxid(TiO₂)-Partikel eingefärbt ist.

13. Elektronische Anordnung gemäß Anspruch 12, wobei die Titandioxid-Partikel im Abdeckmaterial (10) mit einem Anteil zwischen 25 Gewichtsprozent und bis zu 70 Gewichtsprozent sind.

14. Elektronische Anordnung gemäß einem der vorigen Ansprüche,
- das Kontaktmaterial (4) um das optoelektronische Bauelement (3a) an allen Seiten erkennbar ist,
- die Verbindungsfläche (6) zwischen den Bereichen mit freiliegendem Kontaktmaterial (4) und der Deckfläche (5) erkennbar ist, wobei das Kontaktmaterial (4) und die Verbindungsfläche (6) im Vergleich zur Deckfläche (5) dunkel gefärbt sind und sich von der Deckfläche (5) im Hinblick auf Farbe und Helligkeit abheben,
- das Abdeckmaterial (10) auf den Bereich (15, 16, 17, 18, 19) mit der freiliegenden Verbindungsfläche (6) und dem freiliegenden Kontaktmaterial (4) aufgebracht ist, und
- der vom Abdeckmaterial (10) abgedeckte Bereich (15, 16, 17, 18, 19) das optoelektronische Bauelement (3a) vollumfänglich umgibt.

15. Elektronische Anordnung gemäß einem der vorigen Ansprüche, bei der das Kontaktmaterial (4) zwischen dem Träger (2) und dem Bauelement (3a) angeordnet ist und seitlich unter dem Bauelement (3a) hervorragt, wobei das für einen Betrachter um das Bauelement (3a) an allen Seiten erkennbare Kontaktmaterial (4) mit dem Abdeckmaterial (10) abgedeckt ist.

## Claims

1. An electronic arrangement (1) comprising:
- a carrier (2),
- at least one connecting surface (6) on the carrier (2),
- at least one optoelectronic component (3a) which is fixed at least on the connecting surface (6) by a contact material (4),
- a cover surface (5) surrounding the connecting surface (6) on the carrier (2), wherein the contact material (4) is dark colored compared to the cover surface (5) and has regions not covered by the optoelectronic component (3a),
- at least one covered region (15, 16, 17, 18, 19) which is covered by a covering material (10), wherein the covered region comprises side surfaces (7) of the optoelectronic component (3a), the regions of the connecting surface (6) not covered by the optoelectronic component (3a) and the regions of the contact material (4) not covered by the optoelectronic component (3a), wherein the covered region is completely covered with the covering material (10) and the covering material (10) is formed in such a way that an optical contrast between the cover surface (5) and the covered region (15, 16, 17, 18, 19) is minimized in that the cover surface (5) and the covering material (10) are each highly reflective with a reflectivity of greater than 70 % and a difference in the reflectivity of the cover surface (5) to the reflectivity of the covering material (10) is less than 20 %, and
- the optoelectronic component (3a) is formed in such a way that electromagnetic radiation can be emitted through a surface of the optoelectronic component (3a) remote from the carrier (2), and
- the surface of the optoelectronic component (3a) facing away from the carrier (2) has no covering material (10).

2. The electronic arrangement according to claim 1, wherein a difference in the reflectivity of the cover surface (5) to the reflectivity of the covering material (10) is less than 10 %.

3. The electronic arrangement according to one of claims 1 or 2, wherein the optical contrast is a color contrast and/or a brightness contrast, wherein the covering material (10) and the cover surface (5) have similar or identical reflectivity and/or colors so that the optical contrast between the cover surface (5) and the covered region (15) is minimized.

4. The electronic arrangement according to one of the previous claims comprising at least one non-optoelectronic component (3b, 3c) which is fixed on the connecting surface (6) by the contact material (4).

5. The electronic arrangement according to claim 4, wherein the non-optoelectronic component (3b, 3c) is completely covered by the covering material (10).

6. The electronic arrangement according to one of the previous claims, wherein the optoelectronic component (3a) comprises an LED.

7. The electronic arrangement according to claim 4, wherein the non-optoelectronic component (3b, 3c) comprises an ESD semiconductor chip or a passive component.

8. The electronic arrangement according to claim 4, wherein a surface (8, 8a) of the non-optoelectronic component (3b, 3c) facing away from the carrier (2) is arranged in the covered region (17, 19).

9. The electronic arrangement according to one of claims 4 or 5, wherein the covered region (15, 16, 17, 18, 19) comprises the regions of the contact material (4) not covered by the non-optoelectric component (3b, 3c).

10. The electronic arrangement according to one of the previous claims, wherein the cover surface (5) comprises a ceramic or white material or a laminated epoxy resin or solder resist.

11. The electronic arrangement according to one of the previous claims, wherein the covering material (10) comprises a colored silicone or at least one colored epoxy resin, or solder resist or thermoplastic.

12. The electronic arrangement according to claim 11, wherein the covering material (10) is colored by pigments (11) or by titanium dioxide (TiO₂) particles.

13. The electronic arrangement according to claim 12, wherein the titanium dioxide particles in the covering material (10) are between 25 % by weight and up to 70 % by weight.

14. The electronic arrangement according to one of the previous claims,
- the contact material (4) around the optoelectronic component (3a) is recognizable on all sides,
- the connecting surface (6) is recognizable between the regions having exposed contact material (4) and the cover surface (5), wherein the contact material (4) and the connecting surface (6) are dark-colored in comparison with the cover surface (5) and stand out from the cover surface (5) in terms of color and brightness,
- the covering material (10) is applied to the region (15, 16, 17, 18, 19) having the exposed connecting surface (6) and the exposed contact material (4), and
- the region (15, 16, 17, 18, 19) covered by the covering material (10) completely surrounds the optoelectronic component (3a).

15. The electronic arrangement according to one of the previous claims, in which the contact material (4) is arranged between the carrier (2) and the component (3a) and projects laterally below the component (3a), wherein the contact material (4), which - to an observer - is recognizable around the component (3a) on all sides, is covered by the covering material (10).

## Revendications

1. Dispositif électronique (1) comportant:
- un support (2),
- au moins une surface d'interconnexion (6) sur le support (2),
- au moins un composant optoélectronique (3a) qui est fixé au moins sur la surface d'interconnexion (6) au moyen d'un matériau de contact (4),
- une surface de recouvrement (5) entourant la surface d'interconnexion (6) sur le support (2), le matériau de contact (4) étant de couleur foncée par rapport à la surface de recouvrement (5) et présentant des zones non couvertes par le composant optoélectronique (3a),
- au moins une zone couverte (15, 16, 17, 18, 19) recouverte d'un matériau de recouvrement (10),
la zone couverte comprenant des surfaces latérales (7) du composant optoélectronique (3a), les zones de la surface d'interconnexion (6) non recouvertes par le composant optoélectronique (3a) et les zones du matériau de contact (4) non recouvertes par le composant optoélectronique (3a), la zone couverte étant entièrement recouverte par le matériau de recouvrement (10) et le matériau de recouvrement (10) étant conçu de telle sorte qu'un contraste optique entre la surface de recouvrement (5) et la zone couverte (15, 16, 17, 18, 19) est minimisé par le fait que la surface de recouvrement (5) et ledit matériau de recouvrement (10) sont chacun hautement réfléchissants avec une réflectivité supérieure à 70 % et une différence entre la réflectivité de ladite surface de recouvrement (5) et la réflectivité dudit matériau de recouvrement (10) inférieure à 20 %, et
- le composant optoélectronique (3a) est conçu de telle sorte qu'un rayonnement électromagnétique peut être émis à travers une surface du composant optoélectronique (3a) opposée au support (2), et
- la surface du composant optoélectronique (3a) opposée au support (2) ne présente pas de matériau de recouvrement (10) .

2. Dispositif électronique selon la revendication 1,
dans lequel une différence entre la réflectivité de la surface de recouvrement (5) et la réflectivité du matériau de recouvrement (10) est inférieure à 10 %.

3. Dispositif électronique selon l'une des revendications 1 ou 2, dans lequel le contraste optique est un contraste de couleur et/ou un contraste de luminosité, le matériau de recouvrement (10) et la surface de recouvrement (5) présentant une réflectivité et/ou des couleurs similaires ou identiques, de manière à minimiser le contraste optique entre la surface de recouvrement (5) et la zone couverte (15).

4. Dispositif électronique selon l'une des revendications précédentes, comprenant au moins un composant non-optoélectronique (3b, 3c) fixé sur la surface d'interconnexion (6) au moyen du matériau de contact (4).

5. Dispositif électronique selon la revendication 4, le composant non-optoélectronique (3b, 3c) étant entièrement recouvert par un matériau de recouvrement (10).

6. Dispositif électronique selon l'une des revendications précédentes, le composant optoélectronique (3a) comprenant une LED.

7. Dispositif électronique selon la revendication 4, dans lequel le composant non-optoélectronique (3b, 3c) comprend une ESD puce semi-conductrice ou un composant passif.

8. Dispositif électronique selon la revendication 4, dans lequel une surface (8, 8a) du composant non-optoélectronique (3b, 3c) opposée au support (2) est disposée dans la zone couverte (17, 19).

9. Dispositif électronique selon l'une des revendications 4 ou 5, dans lequel la zone couverte (15, 16, 17, 18, 19) comprend les zones du matériau de contact (4) non recouvertes par le composant non-optoélectrique (3b, 3c).

10. Dispositif électronique selon l'une des revendications précédentes, dans lequel la surface de recouvrement (5) comprend un matériau céramique ou blanc ou une résine époxy stratifiée ou une réserve de soudure.

11. Dispositif électronique selon l'une des revendications précédentes, dans lequel le matériau de recouvrement (10) comprend une silicone colorée ou au moins une résine époxy colorée, ou encore une réserve de soudure ou un thermoplastique.

12. Dispositif électronique selon la revendication 11, dans lequel le matériau de recouvrement (10) est coloré par des pigments (11) ou par des particules de dioxyde de titane (TiO₂).

13. Dispositif électronique selon la revendication 12, dans lequel les particules de dioxyde de titane dans le matériau de recouvrement (10) sont comprises dans une proportion comprise entre 25 % en poids et 70 % en poids.

14. Dispositif électronique selon l'une des revendications précédentes, dans lequel
- le matériau de contact (4) autour du composant optoélectronique (3a) est visible sur tous les côtés,
- la surface d'interconnexion (6) entre les zones présentant un matériau de contact (4) exposé et la surface de recouvrement (5) est reconnaissable, le matériau de contact (4) et la surface d'interconnexion (6) étant de couleur foncée par rapport à la surface de recouvrement (5) et se distinguant de la surface de recouvrement (5) en termes de couleur et de luminosité,
- le matériau de recouvrement (10) est appliqué sur la zone (15, 16, 17, 18, 19) avec la surface d'interconnexion exposée (6) et le matériau de contact exposé (4), et
- la zone (15, 16, 17, 18, 19) recouverte par le matériau de recouvrement (10) entoure complètement le composant optoélectronique (3a).

15. Dispositif électronique selon l'une des revendications précédentes, dans lequel le matériau de contact (4) est disposé entre le support (2) et le composant (3a) et ressort latéralement sous le composant (3a), le matériau de contact (4) entourant le composant (3a) et visible sur tous ses côtés aux yeux d'un observateur étant recouvert du matériau de recouvrement (10).
